# EUROPEAN PATENT SPECIFICATION

(11) **EP 3 416 041 B1**
(45) Date of publication and mention of the grant of the patent: **18.11.2020**
(21) Application number: 17812766.8
(22) Date of filing: 16.06.2017
(51) Int. Cl.: G06F 3/16, H03G 7/00

(54) **SOUND EFFECT PROCESSING METHOD, AND TERMINAL DEVICE**
KLANGEFFEKTVERARBEITUNGSVERFAHREN UND ENDGERÄTEVORRICHTUNG
PROCÉDÉ DE TRAITEMENT D'EFFET SONORE ET DISPOSITIF TERMINAL

(30) Priority: 16.06.2016 CN 201610438610
(43) Date of publication of application: 19.12.2018
(73) Proprietor: GUANGDONG OPPO MOBILE TELECOMMUNICATIONS CORP., LTD., Wusha, Chang'an Dongguan, Guangdong 523860 (CN)
(72) Inventor: LI, Yajun, Dongguan Guangdong 523860 (CN); GAN, Gaoting, Dongguan Guangdong 523860 (CN); TU, Guang, Dongguan Guangdong 523860 (CN); YANG, Hai, Dongguan Guangdong 523860 (CN)
(74) Representative: Manitz Finsterwald Patent- und Rechtsanwaltspartnerschaft mbB
(86) International application number: PCT/CN2017/088749
(87) International publication number: WO 2017/215655

(56) References cited:
- EP-A2- 2 282 403
- CN-A- 101 174 818
- CN-A- 104 699 447
- CN-A- 106 126 164
- JP-A- H01 149 508
- US-A1- 2007 110 260
- Fitzgerald Archibald J.: "Automatic Level Controller for Speech Signals Using PID Controllers", Texas Instruments White Paper SPRAAJ4, 1 July 2008 (2008-07-01), XP055275733, Retrieved from the Internet: URL:http://www.ti.com.cn/cn/lit/wp/spraaj4 /spraaj4.pdf [retrieved on 2016-05-26]

## Description

### TECHNICAL FIELD

The present disclosure relates to the technical field of intelligent terminals, and particularly to a method and terminal equipment for sound effect processing. Related technologies are known from JP H01 149508 A and Fitzgerald Archibald J.: "Automatic Level Controller for Speech Signals Using PID Controllers", Texas Instruments White Paper SPRAAJ4, 1 July 2008.

### BACKGROUND

Along with development of an intelligent terminal technology, various intelligent terminals emerge on the market one after another. Functions and applications of the intelligent terminals also become increasingly rich. An audio playing function is a basic function most intelligent terminals have. An audio module is required to be called for audio playing of many applications in a terminal, for example, playing a game sound effect, music and a video sound effect.

In practice, some audio files have relatively great rhythm undulations and volume changes, for example, calming and low music suddenly turns to fast and loud music. At this point, a suddenly quickened rhythm and a suddenly increased volume may not only increase sound effect power consumption of terminal equipment but also damage hearing of a user and do harm to health of the user.

### SUMMARY

Embodiments of the disclosure provide a method and terminal equipment for sound effect processing, which may protect hearing of a user and reduce sound effect power consumption of the terminal equipment. The present invention is defined in the independent claims.

According to a first aspect, a method for sound effect processing is provided. The method may include the following actions.

When an audio file is being played in terminal equipment, a maximum volume difference for a currently read audio segment of the audio file is detected. The maximum volume difference is a difference between a maximum volume and a minimum volume of the audio segment.

Responsive to the maximum volume difference being larger than a preset difference, a first sub-segment, of which a volume is higher than a first preset volume, in the audio segment, is determined.

A playing volume of the first sub-segment is decreased.

According to a second aspect, a device for sound effect processing is provided. The device may include a detection unit, a determination unit and a decrease unit.

The detection unit is configured to, when an audio file is being played in a terminal equipment, detect a maximum volume difference for a currently read audio segment of the audio file. The maximum volume difference is a difference between a maximum volume and a minimum volume of the audio segment.

The determination unit is configured to, responsive to the maximum volume difference being larger than a preset difference, determine a first sub-segment, of which a volume is higher than a first preset volume, in the audio segment.

The decrease unit is configured to decrease a playing volume of the first sub-segment.

According to a third aspect, a terminal equipment is provided. The terminal equipment may include a processor, a memory, a communication interface and a communication bus. The processor, the memory and the communication interface may be connected to each other through the communication bus. The memory may store an executable program code, and the communication interface may be configured for wireless communication; and the processor may be configured to call the executable program code stored in the memory to execute the method for sound effect processing in the first aspect or any optional embodiment of the first aspect of the embodiments of the disclosure.

According to a fourth aspect, a computer-readable storage medium is provided, where an instruction may be stored in the computer-readable storage medium, and when being operated on a computer, may cause the computer to execute any method in the first aspect.

In the embodiments of the disclosure, when the audio file is being played in the terminal equipment, the maximum volume difference for the currently read audio segment of the audio file is detected. The maximum volume difference is a difference between a maximum volume and a minimum volume of the audio segment. Responsive to the maximum volume difference being larger than a preset difference, the first sub-segment of which the volume is higher than the first preset volume in the audio segment, is determined. A playing volume of the first sub-segment is decreased. According to the embodiments of the disclosure, a playing volume of an audio segment of which the volume is excessively high in the audio file may be decreased in advance so as to protect hearing of a user and reduce sound effect power consumption of the terminal equipment.

### BRIEF DESCRIPTION OF DRAWINGS

In order to describe the technical solutions in the embodiments of the application more clearly, the drawings required to be used in descriptions about the embodiments will be simply introduced below.
FIG. 1 illustrates a flowchart of a method for sound effect processing according to an embodiment of the disclosure.
FIG. 2 illustrates a flowchart of a method for sound effect processing according to another embodiment of the disclosure.
FIG. 3 illustrates a structure diagram of a device for sound effect processing according to an embodiment of the disclosure.
FIG. 4 illustrates a structure diagram of a device for sound effect processing according to another embodiment of the disclosure.
FIG. 5 illustrates a structure diagram of terminal equipment according to an embodiment of the disclosure.

### DETAILED DESCRIPTION

The technical solutions in the embodiments of the disclosure will be clearly and completely described below in combination with the drawings in the embodiments of the disclosure. Obviously, the described embodiments are not all embodiments but part of embodiments of the disclosure.

The embodiments of the disclosure provide a method and terminal equipment for sound effect processing, which may protect hearing of a user and reduce sound effect power consumption of the terminal equipment. In the embodiments of the disclosure, the terminal equipment may include various terminals with an audio playing function, including a mobile phone, a tablet computer, a notebook computer, a Personal Digital Assistant (PDA), a Mobile Internet Device (MID), a multimedia player (for example, a Moving Picture Experts Group Audio Layer-3 (MP3) player and a Compact Disc (CD) player), and there are no limits made in the embodiments of the disclosure.

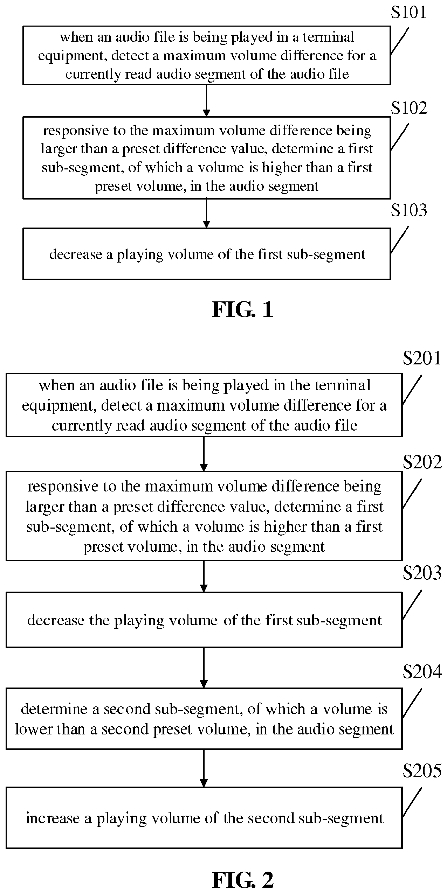

FIG. 1 illustrates a flowchart of a method for sound effect processing according to an embodiment of the disclosure. The method for sound effect processing may be executed by a terminal equipment. As illustrated in FIG. 1, the method may include the following actions.

In S101, when an audio file is being played in a terminal equipment, a maximum volume difference for a currently read audio segment of the audio file is detected.

The maximum volume difference is a difference between a maximum volume and a minimum volume of the audio segment. The audio segment may be a short segment in the audio file or a complete audio file.

According to an aspect, when the audio file is being played in the terminal equipment, if a data size of the audio file is relatively large or a duration of the audio file is relatively long, the audio file may be divided into at least two audio segments according to the data size or the duration. Before an audio segment is played, for example, when a previous audio segment is played, or an audio playing request is processed, the terminal equipment may read the audio segment to be played in advance and detect a maximum volume difference for the audio segment.

In S102, responsive to the maximum volume difference being larger than a preset difference, a first sub-segment, of which a volume is higher than a first preset volume, in the audio segment, is determined.

In the aspect of the disclosure, the audio segment of which the maximum volume difference is larger than the preset difference may further be divided into multiple sub-segments. According to an aspect of the disclosure, when the audio segment is divided according to the data size, the audio segment may be divided into multiple sub-segments according to a smaller data size. For example, an audio segment with a data size of 200KB may be divided into 20 sub-segments with sizes of 10KB. When the audio segment is divided according to the duration, the audio segment may be divided into multiple sub-segments according to a shorter duration. For example, an audio segment with a duration of 10s may be divided into 5 sub-segments with durations of 2s.

According to an aspect, the terminal equipment may store the preset difference, and the preset difference may be taken as a basis for judging whether the maximum volume difference reaches a triggering condition or not. Responsive to the maximum volume difference is larger than the preset difference, volume regulation over the audio segment may be triggered.

According to an aspect, the terminal equipment may also store a value of the first preset volume, and the value of the first preset volume is larger than the maximum volume difference. For example, when the maximum volume difference is 70dB, the first preset volume may be 90dB. In the embodiment of the disclosure, when the maximum volume difference is larger than the preset difference and an audio playing volume is higher than the first preset volume, it is considered that a volume change may make the user feel uncomfortable. At this point, the first sub-segment of which the volume is higher than the first preset volume in the audio segment may be determined.

In S103, a playing volume of the first sub-segment is decreased.

According to an aspect, a first regulation ratio may be determined according to a ratio of the maximum volume of the audio segment to the first preset volume. The playing volume of the first sub-segment is decreased according to the first regulation ratio. For example, when the ratio of the maximum volume of the audio segment to the first preset volume is 2:3, the playing volume of the first sub-segment is regulated to be 2/3 of the original volume.

According to an aspect, a first regulation amount may further be determined according to a difference between the maximum volume of the audio segment and the first preset volume. The playing volume of the first sub-segment is decreased according to the first regulation amount. For example, when the difference between the maximum volume of the audio segment and the first preset volume is 10dB, the playing volume of the first sub-segment may be decreased by 10dB.

According to an aspect, the first sub-segment is a sub-segment of which the volume is higher than the first preset volume and may damage the hearing of the user. Decreasing the playing volume of the first sub-segment may not only protect the hearing of the user but also reduce power consumption.

In the aspect of the disclosure, when the audio file is being played in the terminal equipment, the maximum volume difference for the currently read audio segment of the audio file is detected. The maximum volume difference is the difference between the maximum volume and minimum volume of the audio segment. When the maximum volume difference is larger than the preset difference, the first sub-segment of which the volume is higher than the first preset volume in the audio segment is determined. The playing volume of the first sub-segment is decreased. According to an aspect, a playing volume of an audio segment of which the volume is excessively high in the audio file may be decreased in advance so as to protect hearing of a user and reduce sound effect power consumption of the terminal equipment.

FIG. 2 is a flowchart of a method for sound effect processing according to another embodiment of the disclosure. The method for sound effect processing may be executed by a terminal equipment. As illustrated in FIG. 2, the method may include the following actions.

In S201, when an audio file is being played in terminal equipment, a maximum volume difference for a currently read audio segment of the audio file, is detected.

In S202, responsive to the maximum volume difference being larger than a preset difference, a first sub-segment, of which a volume is higher than a first preset volume, in the audio segment is determined.

In S203, the playing volume of the first sub-segment is decreased.

In the aspect of the disclosure, specific implementation modes of actions S201 to S203 may refer to related descriptions about actions S101 to S103 in the aspect illustrated in FIG. 1 and will not be elaborated herein.

In S204, a second sub-segment, of which a volume is lower than a second preset volume, in the audio segment is determined.

According to an aspect, the terminal equipment may store a value of the second preset volume, and the value of the second preset volume is smaller than a value of the first preset volume. The value of the second preset volume may be a preset fixed value and may also be set and stored in real time according to a volume of a present environmental noise. When the second preset volume is set according to the volume of the environmental noise, the value of the second preset volume should be larger than the volume of the present environmental noise.

According to an aspect, when the audio playing volume is lower than the second preset volume, it is considered that the volume is too low and makes it impossible for the user to hear clearly. At this point, the second sub-segment of which the volume is lower than the second preset volume in the audio segment may be determined.

In S205, the playing volume of the second sub-segment is increased.

According to an aspect, a second regulation ratio may be determined according to a ratio of the minimum volume of the audio segment to the second preset volume; and the playing volume of the second sub-segment is increased according to the second regulation ratio. For example, if the ratio of the minimum value of the audio segment to the second preset volume is 2:3, the playing volume of the second sub-segment may be regulated to be 1.5 times the original volume.

In some optional embodiments, a second regulation amount may be determined according to a difference between the minimum volume of the audio segment and the second preset volume; and the playing volume of the second sub-segment is increased according to the second regulation amount. For example, when the difference between the minimum volume of the audio segment and the second preset volume is 10dB, the playing volume of the second sub-segment may be increased by 10dB.

According to an aspect of the disclosure, the increased volume of the second sub-segment should be lower than the first preset volume.

In the embodiment of the disclosure, when the audio file is being played in the terminal equipment, the maximum volume difference for the currently read audio segment of the audio file is detected. The maximum volume difference is the difference between the maximum volume and minimum volume of the audio segment. The maximum volume difference is larger than the preset difference. The first sub-segment of which the volume is higher than the first preset volume in the audio segment is determined. The playing volume of the first sub-segment is decreased. The second sub-segment of which the volume is lower than the second preset volume in the audio segment is determined; and the playing volume of the second sub-segment is increased. According to the embodiments of the disclosure, a playing volume of an audio segment of which the volume is excessively high in the audio file may be decreased in advance so as to protect hearing of a user and reduce sound effect power consumption of the terminal equipment. A playing volume of an audio segment of which the volume is too low in the audio file may also be increased in advance to enhance an auditory experience of the user.

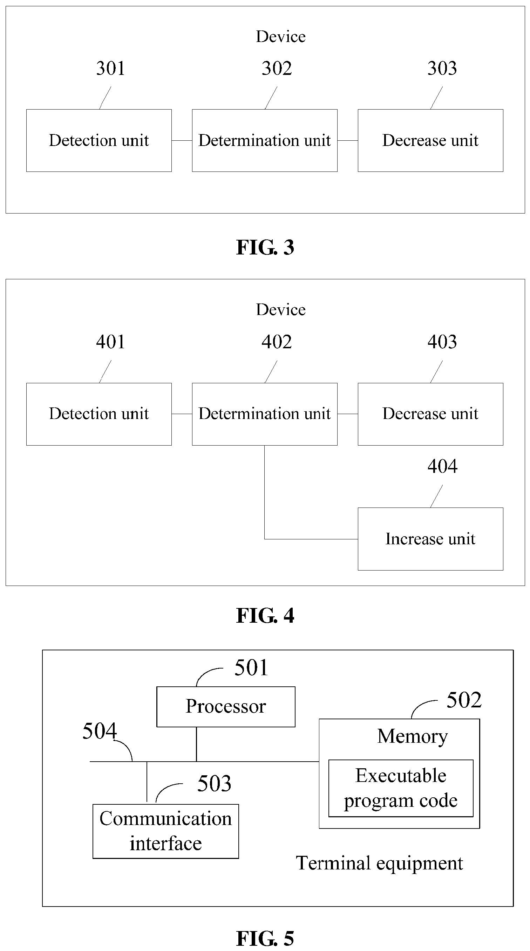

FIG. 3 illustrates a structure diagram of a device for sound effect processing according to an embodiment of the disclosure. As illustrated in FIG. 3, the device may include the following units.

A detection unit 301 is configured to, when an audio file is being played in a terminal equipment, detect a maximum volume difference for a currently read audio segment of the audio file. The maximum volume difference is a difference between a maximum volume and a minimum volume of the audio segment.

According to an aspect, when the audio file is being played in the terminal equipment, if a data size of the audio file is relatively large or a duration of the audio file is relatively long, the audio file may be divided into at least two audio segments according to the data size or the duration. Before an audio segment is played, for example, when a previous audio segment is played, or an audio playing request is processed, the terminal equipment may read the audio segment to be played in advance and detect a maximum volume difference for the audio segment.

A determination unit 302 is configured to, when the maximum volume difference is larger than a preset difference, determine a first sub-segment, of which a volume is higher than a first preset volume, in the audio segment.

In the embodiment of the disclosure, the audio segment of which the maximum volume difference is larger than the preset difference may further be divided into multiple sub-segments. According to an aspect of the disclosure, when the audio segment is divided according to the data size, the audio segment may be divided into multiple sub-segments according to a smaller data size. For example, an audio segment with a data size of 200KB may be divided into 20 sub-segments with sizes of 10KB. If the audio segment is divided according to the duration, the audio segment may be divided into multiple sub-segments according to a shorter duration. For example, an audio segment with a duration of 10s may be divided into 5 sub-segments with durations of 2s.

According to an aspect, the terminal equipment may store the preset difference, and the preset difference may be taken as a basis for judging whether the maximum volume difference reaches a triggering condition. When the maximum volume difference is larger than the preset difference, volume regulation over the audio segment may be triggered.

According to an aspect, the terminal equipment may also store a value of the first preset volume, and the value of the first preset volume is larger than the maximum volume difference. For example, when the maximum volume difference is 70dB, the first preset volume may be 90dB. In the embodiment of the disclosure, when the maximum volume difference is larger than the preset difference and an audio playing volume is higher than the first preset volume, it is considered that a volume change may make the user feel uncomfortable. At this point, the first sub-segment of which the volume is higher than the first preset volume in the audio segment may be determined.

A decrease unit 303 is configured to decrease the playing volume of the first sub-segment.

According to an aspect, the decrease unit 303 may determine a first regulation ratio according to a ratio of the maximum volume of the audio segment to the first preset volume and decrease the playing volume of the first sub-segment according to the first regulation ratio. For example, when the ratio of the maximum volume of the audio segment to the first preset volume is 2:3, the playing volume of the first sub-segment is regulated to be 2/3 of the original volume.

According to an aspect, the decrease unit 303 may further determine a first regulation amount according to a difference between the maximum volume of the audio segment and the first preset volume and decrease the playing volume of the first sub-segment according to the first regulation amount. For example, when the difference between the maximum volume of the audio segment and the first preset volume is 10dB, the playing volume of the first sub-segment may be decreased by 10dB.

According to an aspect, the first sub-segment is a sub-segment of which the volume is higher than the first preset volume and may damage the hearing of the user. Decreasing the playing volume of the first sub-segment may not only protect the hearing of the user but also reduce power consumption.

According to an aspect, when the audio file is being played in the terminal equipment, the maximum volume difference for the currently read audio segment of the audio file is detected. The maximum volume difference is the difference between the maximum volume and minimum volume of the audio segment. When the maximum volume difference is larger than the preset difference, the first sub-segment of which the volume is higher than the first preset volume in the audio segment is determined. The playing volume of the first sub-segment is decreased. According to the embodiments of the disclosure, a playing volume of an audio segment of which the volume is excessively high in the audio file may be decreased in advance to protect hearing of a user and reduce sound effect power consumption of the terminal equipment.

FIG. 4 illustrates a structure diagram of a device for sound effect processing according to another embodiment of the disclosure. As illustrated in FIG. 4, the device may include the following units.

A detection unit 401 is configured to, when an audio file is being played in terminal equipment, detect a maximum volume difference for a currently read audio segment of the audio file. The maximum volume difference is a difference between a maximum volume and minimum volume of the audio segment.

A determination unit 402 is configured to, when the maximum volume difference is larger than a preset difference, determine a first sub-segment, of which a volume is higher than a first preset volume, in the audio segment.

A decrease unit 403 is configured to decrease the playing volume of the first sub-segment.

In the embodiment of the disclosure, specific implementation modes of the detection unit 401, the determination unit 402 and the decrease unit 403 may refer to related descriptions in the embodiment illustrated in FIG. 3 and will not be elaborated herein.

According to an aspect, the determination unit 402 is further configured to determine a second sub-segment, of which a volume is lower than a second preset volume, in the audio segment.

According to an aspect, the terminal equipment may store a value of the second preset volume, and the value of the second preset volume is smaller than a value of the first preset volume. The value of the second preset volume may be a preset fixed value and may also be set and stored in real time according to a volume of a present environmental noise. When the second preset volume is set according to the volume of the environmental noise, the value of the second preset volume should be larger than the volume of the present environmental noise.

According to an aspect, when the audio playing volume is lower than the second preset volume, it is considered that the volume is too low and makes it impossible for the user to hear clearly. At this point, the second sub-segment of which the volume is lower than the second preset volume in the audio segment may be determined.

An increase unit 404 is configured to increase the playing volume of the second sub-segment.

According to an aspect, the increase unit 404 may determine a second regulation ratio according to a ratio of the minimum volume of the audio segment to the second preset volume and increase the playing volume of the second sub-segment according to the second regulation ratio. For example, when the ratio of the minimum value of the audio segment to the second preset volume is 2:3, the playing volume of the second sub-segment may be regulated to be 1.5 times the original volume.

According to an aspect, the increase unit 404 may determine a second regulation amount according to a difference between the minimum volume of the audio segment and the second preset volume and increase the playing volume of the second sub-segment according to the second regulation amount. For example, when the difference between the minimum volume of the audio segment and the second preset volume is 10dB, the playing volume of the second sub-segment may be increased by 10dB.

According to an aspect of the disclosure, the increased volume of the second sub-segment should be lower than the first preset volume.

According to an aspect, when the audio file is being played in the terminal equipment, the maximum volume difference for the currently read audio segment of the audio file is detected. The maximum volume difference is the difference between the maximum volume and the minimum volume of the audio segment. When the maximum volume difference is larger than the preset difference, the first sub-segment of which the volume is higher than the first preset volume in the audio segment is determined. The playing volume of the first sub-segment is decreased. The second sub-segment of which the volume is lower than the second preset volume in the audio segment is determined. The playing volume of the second sub-segment is increased. According to an aspect, a playing volume of an audio segment of which the volume is excessively high in the audio file may be decreased in advance so as to protect hearing of a user and reduce sound effect power consumption of the terminal equipment. A playing volume of an audio segment of which the volume is too low in the audio file may also be increased in advance to enhance an auditory experience of the user.

FIG. 5 illustrates a structure diagram of terminal equipment according to an embodiment of the disclosure. As illustrated in FIG. 5, the terminal equipment may include a processor 501, a memory 502, a communication interface 503 and a communication bus 504. The processor 501, the memory 502 and the communication interface 503 are connected and communicate to each other through the communication bus 504. The processor 501 controls wireless communication with an external cellular network through the communication interface 503. The communication interface 503 includes, but not limited to, an antenna, an amplifier, a transceiver, a coupler, a Low Noise Amplifier (LNA), a duplexer and the like. The memory 502 includes at least one of: a Random Access Memory (RAM), a nonvolatile memory or an external memory. An executable program code is stored in the memory 502, and the processor 501 may call the executable program code to execute the following actions.

When an audio file is being played in terminal equipment, a maximum volume difference for a currently read audio segment of the audio file is detected. The maximum volume difference is a difference between a maximum volume and a minimum volume of the audio segment.

When the maximum volume difference is larger than a preset difference, a first sub-segment, of which a volume is higher than a first preset volume, in the audio segment is determined.

The playing volume of the first sub-segment is decreased.

According to an aspect, before the action, executed by the processor 501, that the maximum volume difference for the currently read audio segment of the audio file is detected, the following actions may further be included.

The audio file is divided into at least two audio segments.

Responsive to one of the audio segments being played, a next one of the audio segments is read.

The action that the maximum volume difference for the currently read audio segment of the audio file is detected includes the following actions.

A maximum volume difference for the next audio segment is detected.

According to an aspect, the action that the audio file is divided into the at least two audio segments includes the following actions.

The audio file is divided into at least two audio segments according to a data size or an audio duration of the audio file.

According to an aspect, the first preset volume is higher than the maximum volume difference.

According to an aspect, the action, executed by the processor 501, that the playing volume of the first sub-segment is decreased may include the following actions.

A first regulation ratio is determined according to a ratio of the maximum volume of the audio segment to the first preset volume.

The playing volume of the first sub-segment is decreased according to the first regulation ratio.

According to an aspect, the action, executed by the processor 501, that the playing volume of the first sub-segment is decreased may include the following actions.

A first regulation amount is determined according to a difference between the minimum volume of the audio segment and the second preset volume.

The playing volume of the first sub-segment is decreased according to the first regulation amount.

According to an aspect, the processor 501 may further call the executable program code to execute the following actions.

A second sub-segment, of which a volume is lower than a second preset volume, in the audio segment, is determined.

The playing volume of the second sub-segment is increased.

According to an aspect, the action, executed by the processor 501, that the playing volume of the second sub-segment is increased may include the following actions.

A second regulation ratio is determined according to a ratio of the minimum volume of the audio segment to the second preset volume.

The playing volume of the second sub-segment is increased according to the second regulation ratio.

According to an aspect, the action, executed by the processor 501, that the playing volume of the second sub-segment is increased may include the following actions.

A second regulation amount is determined according to a difference between of the minimum volume of the audio segment and the second preset volume.

The playing volume of the second sub-segment is increased according to the second regulation amount.

According to an aspect, when the audio file is being played in the terminal equipment, the maximum volume difference for the currently read audio segment of the audio file is detected. The maximum volume difference is the difference between the maximum volume and minimum volume of the audio segment. When the maximum volume difference is larger than the preset difference, the first sub-segment of which the volume is higher than the first preset volume in the audio segment, is determined. The playing volume of the first sub-segment is decreased. According to an aspect, a playing volume of an audio segment of which the volume is excessively high in the audio file may be decreased in advance to protect hearing of a user and reduce sound effect power consumption of the terminal equipment.

The modules or units in all the embodiments of the disclosure may be implemented by a universal integrated circuit, for example, a Central Processing unit (CPU) or an Application Specific Integrated Circuit (ASIC).

Sequence regulation, combination and deletion may be performed on the actions in the method of the embodiments of the disclosure according to a practical requirement.

The modules or units in the device of the embodiments of the disclosure may be combined, divided and deleted according to a practical requirement.

Those of ordinary skilled in the art should know that implementation of all or part of the flow in the method of the embodiments may be completed by related hardware instructed by a computer program, the program may be stored in a computer-readable storage medium, and when the program is executed, the flow of the each method embodiment may be included, where the storage medium may be a magnetic disk, an optical disc, a Read-Only Memory (ROM), a RAM and the like.

The matter for which protection is sought is defined in the appended set of claims.

## Claims

1. A method for sound effect processing, comprising:
when an audio file is being played in a terminal equipment, detecting a maximum volume difference for a currently read audio segment of the audio file (S101), the maximum volume difference being a difference between a maximum volume and a minimum volume of the audio segment;
responsive to the maximum volume difference being larger than a preset difference, determining a first sub-segment, of which a volume is higher than a first preset volume, in the audio segment (S102); and
decreasing a playing volume of the first sub-segment (S103).

2. The method for sound effect processing according to claim 1, wherein before detecting the maximum volume difference for the currently read audio segment of the audio file, the method further comprises:
dividing the audio file into at least two audio segments, and
responsive to one of the audio segments being played, reading a next one of the audio segments,
wherein detecting the maximum volume difference for the currently read audio segment of the audio file comprises:
detecting a maximum volume difference for the next audio segment.

3. The method for sound effect processing according to claim 2, wherein dividing the audio file into the at least two audio segments comprises:
dividing the audio file into the at least two audio segments according to a data size or an audio duration of the audio file.

4. The method for sound effect processing according to claim 1, wherein the first preset volume is higher than the maximum volume difference.

5. The method for sound effect processing according to any one of claims 1 to 4, wherein decreasing the playing volume of the first sub-segment (S103) comprises:
determining a first regulation ratio according to a ratio of the maximum volume of the audio segment to the first preset volume; and
decreasing the playing volume of the first sub-segment according to the first regulation ratio.

6. The method for sound effect processing according to any one of claims 1 to 4, wherein decreasing the playing volume of the first sub-segment (S103) comprises:
determining a first regulation amount according to a difference between the maximum volume of the audio segment and the first preset volume; and
decreasing the playing volume of the first sub-segment according to the first regulation amount.

7. The method for sound effect processing according to any one of claims 1 to 4, further comprising:
determining a second sub-segment, of which a volume is lower than a second preset volume, in the audio segment (S204); and
increasing a playing volume of the second sub-segment (S205).

8. The method for sound effect processing according to claim 7, wherein increasing the playing volume of the second sub-segment comprises:
determining a second regulation ratio according to a ratio of the minimum volume of the audio segment to the second preset volume; and
increasing the playing volume of the second sub-segment according to the second regulation ratio.

9. The method for sound effect processing according to claim 7, wherein increasing the playing volume of the second sub-segment comprises:
determining a second regulation amount according to a difference between the minimum volume of the audio segment and the second preset volume; and
increasing the playing volume of the second sub-segment according to the second regulation amount.

10. A device for sound effect processing, comprising:
a detection unit (301), configured to, when an audio file is being played in a terminal equipment, detect a maximum volume difference for a currently read audio segment of the audio file, the maximum volume difference being a difference between a maximum volume and a minimum volume of the audio segment;
a determination unit (302), configured to, responsive to the maximum volume difference being larger than a preset difference, determine a first sub-segment, of which a volume is higher than a first preset volume, in the audio segment; and
a decrease unit (303), configured to decrease a playing volume of the first sub-segment.

11. The device for sound effect processing according to claim 10, wherein the detection unit (301) is configured to:
divide the audio file into at least two audio segments;
responsive to one of the audio segments being played, read a next one of the audio segments; and
detect a maximum volume difference for the next audio segment.

12. The device for sound effect processing according to claim 11, wherein the detection (301) unit is configured to:
divide the audio file into the at least two audio segments according to a data size or an audio duration of the audio file.

13. The device for sound effect processing according to any one of claims 10 to 12, wherein the first preset volume is higher than the maximum volume difference.

14. A terminal equipment, comprising a processor (501) and a memory (502), wherein
the memory (502) stores an executable program code; and
the processor (501) is configured to call the executable program code in the memory (502) to execute the method according to any one of claims 1 to 9.

15. A computer-readable storage medium, wherein an instruction is stored in the computer-readable storage medium which, when being operated on a computer, causes the processor to execute the method according to any one of claims 1 to 9.

## Patentansprüche

1. Verfahren zur Klangeffektverarbeitung, das Folgendes umfasst:
wenn eine Audiodatei in einem Endgerät abgespielt wird, Detektieren einer maximalen Lautstärkedifferenz für ein gegenwärtig gelesenes Audiosegment der Audiodatei (S101), wobei die maximale Lautstärkedifferenz eine Differenz zwischen einer maximalen Lautstärke und einer minimalen Lautstärke des Audiosegments ist;
als Reaktion darauf, dass die maximale Lautstärkedifferenz größer als eine voreingestellte Differenz ist, Bestimmen eines ersten Teilsegments, dessen Lautstärke höher ist als eine erste voreingestellte Lautstärke, in dem Audiosegment (S102); und
Verringern einer Abspiellautstärke des ersten Teilsegments (S103).

2. Verfahren zur Klangeffektverarbeitung nach Anspruch 1, wobei das Verfahren vor dem Detektieren der maximalen Lautstärkedifferenz für das gegenwärtig gelesene Audiosegment der Audiodatei ferner Folgendes umfasst:
Teilen der Audiodatei in mindestens zwei Audiosegmente, und
als Reaktion darauf, dass eines der Audiosegmente abgespielt wird, Lesen eines nächsten der Audiosegmente,
wobei das Detektieren der maximalen Lautstärkedifferenz für das gegenwärtig gelesene Audiosegment der Audiodatei Folgendes umfasst:
Detektieren einer maximalen Lautstärkedifferenz für das nächste Audiosegment.

3. Verfahren zur Klangeffektverarbeitung nach Anspruch 2, wobei das Teilen der Audiodatei in die mindestens zwei Audiosegmente Folgendes umfasst:
Teilen der Audiodatei in die mindestens zwei Audiosegmente gemäß einer Datengröße oder einer Audiolänge der Audiodatei.

4. Verfahren zur Klangeffektverarbeitung nach Anspruch 1, wobei die erste voreingestellte Lautstärke höher ist als die maximale Lautstärkedifferenz.

5. Verfahren zur Klangeffektverarbeitung nach einem der Ansprüche 1 bis 4, wobei das Verringern der Abspiellautstärke des ersten Teilsegments (S103) Folgendes umfasst:
Bestimmen eines ersten Regulierungsverhältnisses gemäß einem Verhältnis der maximalen Lautstärke des Audiosegments zu der ersten voreingestellten Lautstärke; und
Verringern der Abspiellautstärke des ersten Teilsegments gemäß dem ersten Regulierungsverhältnis.

6. Verfahren zur Klangeffektverarbeitung nach einem der Ansprüche 1 bis 4, wobei das Verringern der Abspiellautstärke des ersten Teilsegments (S103) Folgendes umfasst:
Bestimmen eines ersten Regulierungsbetrags gemäß einer Differenz zwischen der maximalen Lautstärke des Audiosegments und der ersten voreingestellten Lautstärke; und
Verringern der Abspiellautstärke des ersten Teilsegments gemäß dem ersten Regulierungsbetrag.

7. Verfahren zur Klangeffektverarbeitung nach einem der Ansprüche 1 bis 4, das ferner Folgendes umfasst:
Bestimmen eines zweiten Teilsegments, dessen Lautstärke geringer ist als eine zweite voreingestellte Lautstärke, in dem Audiosegment (S204); und
Erhöhen einer Abspiellautstärke des zweiten Teilsegments (S205).

8. Verfahren zur Klangeffektverarbeitung nach Anspruch 7, wobei das Erhöhen der Abspiellautstärke des zweiten Teilsegments Folgendes umfasst:
Bestimmen eines zweiten Regulierungsverhältnisses gemäß einem Verhältnis der minimalen Lautstärke des Audiosegments zu der zweiten voreingestellten Lautstärke; und
Erhöhen der Abspiellautstärke des zweiten Teilsegments gemäß dem zweiten Regulierungsverhältnis.

9. Verfahren zur Klangeffektverarbeitung nach Anspruch 7, wobei das Erhöhen der Abspiellautstärke des zweiten Teilsegments Folgendes umfasst:
Bestimmen eines zweiten Regulierungsbetrags gemäß einer Differenz zwischen der minimalen Lautstärke des Audiosegments und der zweiten voreingestellten Lautstärke; und
Erhöhen der Abspiellautstärke des zweiten Teilsegments gemäß dem zweiten Regulierungsbetrag.

10. Vorrichtung zur Klangeffektverarbeitung, die Folgendes umfasst:
eine Detektionseinheit (301), die ausgelegt ist, wenn eine Audiodatei in einem Endgerät abgespielt wird, zum Detektieren einer maximalen Lautstärkedifferenz für ein gegenwärtig gelesenes Audiosegment der Audiodatei, wobei die maximale Lautstärkedifferenz eine Differenz zwischen einer maximalen Lautstärke und einer minimalen Lautstärke des Audiosegments ist;
eine Bestimmungseinheit (302), die ausgelegt ist, als Reaktion darauf, dass die maximale Lautstärkedifferenz größer als eine voreingestellte Differenz ist, zum Bestimmen eines ersten Teilsegments, dessen Lautstärke höher ist als eine erste voreingestellte Lautstärke, in dem Audiosegment; und
eine Verringerungseinheit (303), die ausgelegt ist zum Verringern einer Abspiellautstärke des ersten Teilsegments.

11. Vorrichtung zur Klangeffektverarbeitung nach Anspruch 10, wobei die Detektionseinheit (301) ausgelegt ist zum:
Teilen der Audiodatei in mindestens zwei Audiosegmente;
als Reaktion darauf, dass eines der Audiosegmente abgespielt wird, Lesen eines nächsten der Audiosegmente; und
Detektieren einer maximalen Lautstärkedifferenz für das nächste Audiosegment.

12. Vorrichtung zur Klangeffektverarbeitung nach Anspruch 11, wobei die Detektionseinheit (301) ausgelegt ist zum:
Teilen der Audiodatei in die mindestens zwei Audiosegmente gemäß einer Datengröße oder einer Audiolänge der Audiodatei.

13. Vorrichtung zur Klangeffektverarbeitung nach einem der Ansprüche 10 bis 12, wobei die erste voreingestellte Lautstärke höher ist als die maximale Lautstärkedifferenz.

14. Endgerät, das einen Prozessor (501) und einen Speicher (502) umfasst, wobei
der Speicher (502) einen ausführbaren Programmcode speichert; und
der Prozessor (501) ausgelegt ist zum Aufrufen des ausführbaren Programmcodes im Speicher (502), um das Verfahren nach einem der Ansprüche 1 bis 9 auszuführen.

15. Computerlesbares Speicherungsmedium, wobei eine Anweisung in dem computerlesbaren Speicherungsmedium gespeichert ist, das bei seinem Betrieb auf einem Computer veranlasst, dass der Prozessor das Verfahren nach einem der Ansprüche 1 bis 9 ausführt.

## Revendications

1. Procédé de traitement d'effet sonore, comprenant :
quand un fichier audio est reproduit dans un équipement terminal, la détection d'une différence de volume maximale pour un segment audio en cours de reproduction du fichier audio (S101), la différence de volume maximale étant une différence entre un volume maximum et un volume minimum du segment audio ;
quand la différence de volume maximale est supérieure à une différence prédéfinie, la détermination d'un premier sous-segment, dont un volume est supérieur à un premier volume prédéfini, dans le segment audio (S102) ; et
la diminution d'un volume de reproduction du premier sous-segment (S103).

2. Procédé de traitement d'effet sonore selon la revendication l, le procédé comprenant en outre, avant la détection de la différence de volume maximale pour le segment audio en cours de reproduction du fichier audio :
la division du fichier audio en au moins deux segments audio, et
quand un des segments audio est en cours de reproduction, la lecture d'un segment suivant des segments audio,
dans lequel la détection de la différence de volume maximale du segment audio en cours de reproduction du fichier audio comprend :
la détection d'une différence de volume maximale pour le segment audio suivant.

3. Procédé de traitement d'effet sonore selon la revendication 2, dans lequel la division du fichier audio en les au moins deux segments audio comprend :
la division du fichier audio en les au moins deux segments audio conformément à une taille de données ou une durée audio du fichier audio.

4. Procédé de traitement d'effet sonore selon la revendication l, dans lequel le premier volume prédéfini est supérieur à la différence de volume maximale.

5. Procédé de traitement d'effet sonore selon l'une quelconque des revendications 1 à 4, dans lequel la diminution du volume de reproduction du premier sous-segment (S103) comprend :
la détermination d'un premier rapport de régulation conformément à un rapport du volume maximum du segment audio sur le premier volume prédéfini ; et
la diminution du volume de reproduction du premier sous-segment conformément au premier rapport de régulation.

6. Procédé de traitement d'effet sonore selon l'une quelconque des revendications 1 à 4, dans lequel la diminution du volume de reproduction du premier sous-segment (S103) comprend :
la détermination d'une première quantité de régulation conformément à une différence entre le volume maximum du segment audio et le premier volume prédéfini ; et
la diminution du volume de reproduction du premier sous-segment conformément à la première quantité de régulation.

7. Procédé de traitement d'effet sonore selon l'une quelconque des revendications 1 à 4, comprenant en outre :
la détermination d'un second sous-segment, dont un volume est inférieur à un second volume prédéfini, dans le segment audio (S204) ; et
l'augmentation d'un volume de reproduction du second sous-segment (S205).

8. Procédé de traitement d'effet sonore selon la revendication 7, dans lequel l'augmentation du volume de reproduction du second sous-segment comprend :
la détermination d'un second rapport de régulation conformément à un rapport du volume minimum du segment audio sur le second volume prédéfini ; et
l'augmentation du volume de reproduction du second sous-segment conformément au second rapport de régulation.

9. Procédé de traitement d'effet sonore selon la revendication 7, dans lequel l'augmentation du volume de reproduction du second sous-segment comprend :
la détermination d'une seconde quantité de régulation conformément à une différence entre le volume minimum du segment audio et le second volume prédéfini ; et
l'augmentation du volume de reproduction du second sous-segment conformément à la seconde quantité de régulation.

10. Dispositif de traitement d'effet sonore, comprenant :
une unité de détection (301), configurée pour, quand un fichier audio est en cours de reproduction dans un équipement terminal, détecter une différence de volume maximal pour un segment audio en cours de reproduction du fichier audio, la différence de volume maximale étant une différence entre un volume maximum et un volume minimum du segment audio ;
une unité de détermination (302), configurée pour, quand la différence de volume maximale est supérieure à une différence prédéfinie, déterminer un premier sous-segment, dont un volume est supérieur à un premier volume prédéfini, dans le segment audio ; et
une unité de diminution (303), configurée pour diminuer un volume de reproduction du premier sous-segment.

11. Dispositif de traitement d'effet sonore selon la revendication 10, dans lequel l'unité de détection (301) est configurée pour :
diviser le fichier audio en au moins deux segments audio ;
quand un des segments audio est en cours de reproduction, lire un segment suivant des segments audio ; et
détecter une différence de volume maximale pour le segment audio suivant.

12. Dispositif de traitement d'effet sonore selon la revendication 11, dans lequel l'unité de détection (301) est configurée pour :
diviser le fichier audio en les au moins deux segments audio conformément à une taille de données ou une durée audio du fichier audio.

13. Dispositif de traitement d'effet sonore selon l'une quelconque des revendications 10 à 12, dans lequel le premier volume prédéfini est supérieur à la différence de volume maximale.

14. Equipement terminal, comprenant un processeur (501) et une mémoire (502), dans lequel
la mémoire (502) mémorise un code de programme exécutable ; et
le processeur (501) est configuré pour appeler le code de programme exécutable dans la mémoire (502) afin d'exécuter le procédé selon l'une quelconque des revendications 1 à 9.

15. Support de mémorisation lisible par ordinateur, dans lequel une instruction est mémorisée dans le support de mémorisation lisible par ordinateur qui, à son exploitation sur un ordinateur, amène le processeur à exécuter le procédé selon l'une quelconque des revendications 1 à 9.
